# EUROPEAN PATENT APPLICATION

(11) **EP 4 753 383 A1**
(43) Date of publication of application: **03.06.2026**
(21) Application number: 25204589.3
(22) Date of filing: 25.09.2025
(51) Int. Cl.: H05K 5/02, H05K 7/14, H05K 7/20

(54) **SERVER DEVICE**

(30) Priority: 27.11.2024 CN 202411721721
(71) Applicant: Douyin Vision Co., Ltd., Beijing 100041 (CN)
(72) Inventor: Wang, Ruidong, Beijing, 100028 (CN); Gao, Linan, Beijing, 100028 (CN); Cong, Weidong, Beijing, 100028 (CN); Gui, Chenglong, Beijing, 100028 (CN); Zhao, Zhibo, Beijing, 100028 (CN); Zhang, Ying, Beijing, 100028 (CN); Liu, Tao, Beijing, 100028 (CN); Ren, Yuanlin, Beijing, 100028 (CN); Wang, Jiang, Beijing, 100028 (CN)
(74) Representative: Grünecker Patent- und Rechtsanwälte PartG mbB

(57) **Abstract**

Embodiments of the disclosure provide a server device. A chassis (10) of the server device includes an accommodating cavity (101) and a first opening (11). The accommodating cavity (101) includes a first region (101a) adjacent to a front side of the chassis (10) and a second region (101b) adjacent to a rear side of the chassis (10). The first opening (11) is disposed at a top of the chassis (10) and corresponds to the first region (101a). A carrier board (21) is disposed in the first region (101a). A cover (15) is disposed at the first opening (11) and rotatably coupled to the chassis (10) and switchable between closed and open positions. The cover (15) covers the first opening (11) when in the closed position. When the cover (15) is in the open position, the first opening (11) is exposed for an operator to operate at the first opening (11).

## Description

### FIELD

Embodiments of the present disclosure generally relate to the field of computer system architecture, and in particular, to a server device.

### BACKGROUND

With the advancement of information technologies, higher interconnection bandwidth is required to ensure fast data transmission between multiple devices and prevent communication delay. Therefore, more and more servers adopt multi-card configuration and are connected through high-bandwidth interconnection technologies to meet the requirements. In some conventional server devices, expansion cards are usually disposed inside a chassis of the server device. When these expansion cards need to be maintained or replaced, the server device must be shut down first and then the entire chassis must be disassembled. This process is not only complicated in operation, but also causes the server device to be unable to run continuously, seriously affecting the continuity and stability of services.

### SUMMARY

Embodiments of the present disclosure provide a server device. The server device includes: a chassis including an accommodating cavity and a first opening, the accommodating cavity including a first region adjacent to a front side of the chassis and a second region adjacent to a rear side of the chassis, the first opening being disposed at a top of the chassis and corresponding to the first region; a carrier board disposed in the first region and coupled to the chassis, the carrier board including an interconnection chip; a main board disposed in the second region and coupled to the chassis, the main board including a processing unit; a plurality of expansion cards detachably coupled to a side of the carrier board facing the first opening; and a cover disposed at the first opening, the cover being rotatably coupled to the chassis and switchable between a closed position and an open position, where when the cover is in the closed position, the cover covers the first opening, and when the cover is in the open position, the first opening is exposed for an operator to operate at the first opening.

**It** should be understood that the content described in this section is not intended to identify key or essential features of the embodiments of the present disclosure, nor is it intended to limit the scope of the present disclosure. Other features of the present disclosure will be readily envisaged through the following description.

### BRIEF DESCRIPTION OF DRAWINGS

The above and other features, advantages and aspects of the embodiments of the present disclosure will become more apparent in combination with the drawings and with reference to the following detailed description. In the drawings, the same or similar reference symbols refer to the same or similar elements, where:
FIG. 1 shows a perspective view of a server device according to embodiments of the present disclosure, where a cover is shown in an open position;
FIG. 2 shows a perspective view of the server device according to embodiments of the present disclosure, where the cover is shown in the open position, and an internal structure of the server device is shown;
FIG. 3 shows a schematic diagram of a partial topology of the server device according to embodiments of the present disclosure;
FIG. 4 shows a perspective view of the server device according to embodiments of the present disclosure, where the cover is shown in a closed position;
FIG. 5 shows a perspective view of the server device according to embodiments of the present disclosure, where the cover is shown in the closed position, and the internal structure of the server device is shown;
FIG. 6 shows an enlarged schematic view of part A of FIG. 5;
FIG. 7 shows a perspective view of a liquid cooling assembly according to embodiments of the present disclosure;
FIG. 8 shows a perspective view of the server device according to embodiments of the present disclosure, where a second opening and an air cooling module are shown;
FIG. 9 shows a perspective view of a limiting member according to embodiments of the present disclosure;
FIG. 10 shows a front view of the limiting member according to embodiments of the present disclosure;
FIG. 11 shows a perspective view of an expansion card according to embodiments of the present disclosure;
FIG. 12 shows a cross-sectional view of the expansion card according to embodiments of the present disclosure; and
FIG. 13 shows a perspective view of the expansion card and the limiting member in cooperation according to embodiments of the present disclosure.

### List of reference symbols:

10, chassis; 101, accommodating cavity; 101a, first region; 101b, second region; 102, first latching slot; 11, first opening; 12, second opening; 13, notch; 15, cover; 16, stop assembly; 17, handle; 18, module compartment;
21, carrier board; 22, interconnection chip; 23, main board; 24, processing unit; 25, expansion card; 26, connector; 27, position stop assembly; 271, connecting member; 2711, first protrusion; 2712, second protrusion; 272, fitting member; 2721, second latching slot; 273, button; 274, elastic assembly; 2741, first elastic member; 2742, second elastic member;
31, damping hinge; 32, air cooling module; 33, power module; 34, functional module; 341, power control module; 342, data transmission module; 343, storage module; 35, limiting member; 351, limiting portion; 352, protruding portion; 353, inclined surface; 354, groove;
40, liquid cooling assembly; 41, liquid inlet tube; 42, liquid return tube; 43, first branch; 44, first cold plate; 45, second branch; 46, second cold plate; 47, liquid cooling adapter; 471, liquid inlet; 472, liquid outlet.

### DETAILED DESCRIPTION

Preferred embodiments of the present disclosure will be described in more detail below with reference to the drawings. Although the preferred embodiments of the present disclosure are shown in the drawings, it should be understood that the present disclosure may be implemented in various forms and should not be limited to the embodiments set forth herein. On the contrary, these embodiments are provided for a thorough and complete understanding of the present disclosure, and the scope of the present disclosure may be fully conveyed to those skilled in the art.

As used herein, the term "include/comprise" and its variations represent an open-ended inclusion, that is, "include/comprise but not limited to". Unless otherwise stated, the term "or" means "and/or". The term "based on" means "based at least in part on". The terms "an example embodiment" and "an embodiment" mean "at least one example embodiment". The term "another embodiment" means "at least one other embodiment". The terms "first", "second", etc. may refer to different or same objects.

As described above, in some conventional server devices, expansion cards are usually disposed inside a chassis of the server device. When these expansion cards need to be maintained or replaced, the server device must be shut down first and then the entire chassis must be disassembled. This process is not only complicated in operation, but also causes the server device to be unable to run continuously, seriously affecting the continuity and stability of services.

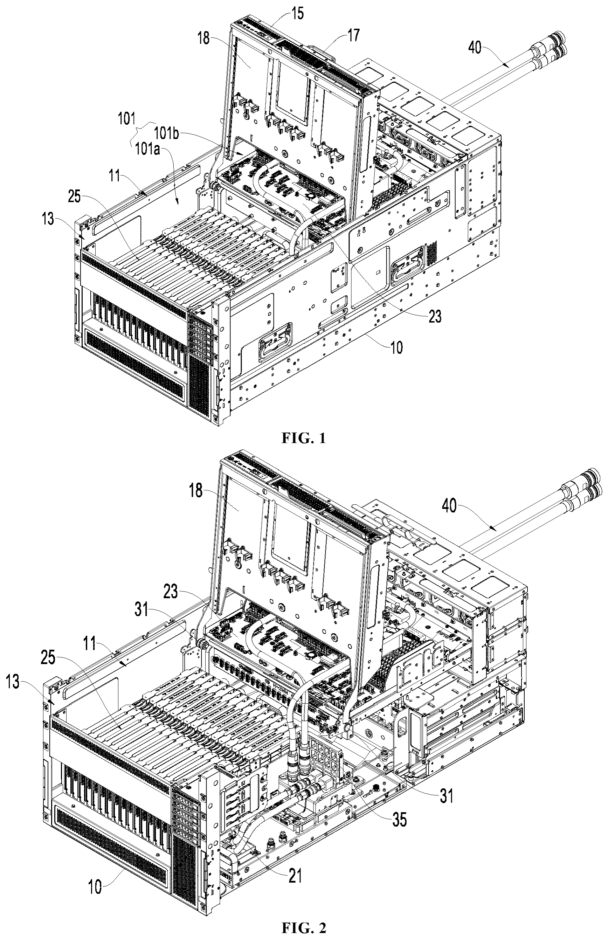

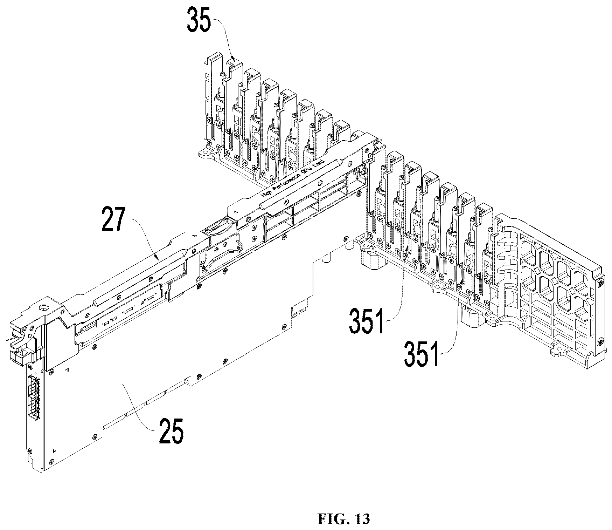

Embodiments of the present disclosure provide a server device. The server device includes a chassis, a carrier board, a main board, a cover, and a plurality of expansion cards. The chassis includes an accommodating cavity and a first opening. The accommodating cavity includes a first region adjacent to a front side of the chassis and a second region adjacent to a rear side of the chassis. The first opening is disposed at a top of the chassis and corresponds to the first region. The carrier board is disposed in the first region and coupled to the chassis. The carrier board includes an interconnection chip. The main board is disposed in the second region and coupled to the chassis. The main board includes a processing unit. The plurality of expansion cards are detachably coupled to a side of the carrier board facing the first opening. The cover is disposed at the first opening. The cover is rotatably coupled to the chassis and switchable between a closed position and an open position. When the cover is in the closed position, the cover covers the first opening. When the cover is in the open position, the first opening is exposed for an operator to operate at the first opening. With this arrangement, the operator only needs to rotate the cover to the open position, and then the expansion cards or other electronic components inside the server device may be maintained and replaced through the first opening. In addition, during the maintenance or replacement operation, the server may keep running continuously, ensuring the continuity and stability of services. The principles of the present disclosure will be described in detail below with reference to FIG. 1 to FIG. 13.

As shown in FIG. 1 to FIG. 4, the server device includes a chassis 10, a carrier board 21, a main board 23, a cover 15, and a plurality of expansion cards 25. The chassis 10 is a housing of the server device, which is used for accommodating and protecting various internal electronic components. The chassis 10 has an accommodating cavity 101 inside, and the electronic components may be arranged in different regions of the accommodating cavity 101 as needed. In some embodiments, the accommodating cavity 101 is divided into two regions, including a first region 101a adjacent to the front side of the chassis 10 and a second region 101b adjacent to the rear side of the chassis 10. In this way, the front and rear partitions facilitate the reasonable layout of the internal space of the chassis 10, improving the space utilization and heat dissipation efficiency. The first opening 11 is disposed at the top of the chassis 10 and corresponds to the first region 101a.

As shown in FIG. 2, the carrier board 21 is disposed in the first region 101a and coupled to the chassis 10. The main function of the carrier board 21 is to provide a platform on which a plurality of expansion cards 25 may be mounted and managed. An interconnection chip 22 is also integrated on the carrier board 21, and the interconnection chip 22 may realize efficient communication between the expansion cards 25, ensuring fast and low-latency data transmission between the plurality of expansion cards 25. In this way, the interconnection chip 22 may significantly improve the parallel processing capability and overall performance of the server device.

As shown in FIG. 1 and FIG. 2, the main board 23 is disposed in the second region 101b and coupled to the chassis 10. The main board 23 is a core control unit of the server device, on which a processing unit 24, such as a CPU, a memory and other key components, is integrated. The processing unit 24 is responsible for executing computing tasks and data processing, and is the key to the server performance. The main board 23 is connected to the carrier board 21 through a high-speed bus, which enables highly efficient data transmission between the processing unit 24 and the expansion cards 25.

As shown in FIG. 1 to FIG. 3, a plurality of expansion cards 25 are detachably coupled to a side of the carrier board 21 facing the first opening 11. The expansion cards 25 may be, for example, processors, network cards, memory cards, etc., which are used to expand the functions and performance of the server. In this way, an operator may replace or upgrade the expansion cards 25 when needed.

As shown in FIG. 1, FIG. 2 and FIG. 4, the cover 15 is disposed at the first opening 11 and rotatably coupled to the chassis 10. The cover 15 is switchable between a closed position and an open position. When the cover 15 is in the closed position, the cover 15 covers the first opening 11, protecting the internal components from external interference. When the cover 15 is in the open position, the first opening 11 is exposed, and the operator may maintain and replace the expansion cards 25 or other electronic components inside the server device at the first opening 11.

With this arrangement, the operator only needs to rotate the cover 15 to the open position, and then the expansion cards 25 or other electronic components inside the server device may be maintained and replaced through the first opening 11. In addition, during the maintenance or replacement operation, the server may keep running continuously, ensuring the continuity and stability of services.

In some embodiments, as shown in FIG. 1 and FIG. 2, in the server device, a height of the carrier board 21 in the accommodating cavity 101 is lower than a height of the main board 23 in the accommodating cavity 101. The interconnection chip 22 is disposed on the carrier board 21 to enable efficient communication between the expansion cards 25, while the processing unit 24, such as a CPU, a memory and other key components, is disposed on the main board 23 and is responsible for executing computing tasks and data processing. Both parts generate a large amount of heat during operation. By arranging the carrier board 21 and the main board 23 at different heights in the accommodating cavity 101, over-concentration of heat may be avoided, thereby improving the heat dissipation effect. In addition, the stability and reliability of the server during long-term high-load operation may also be ensured.

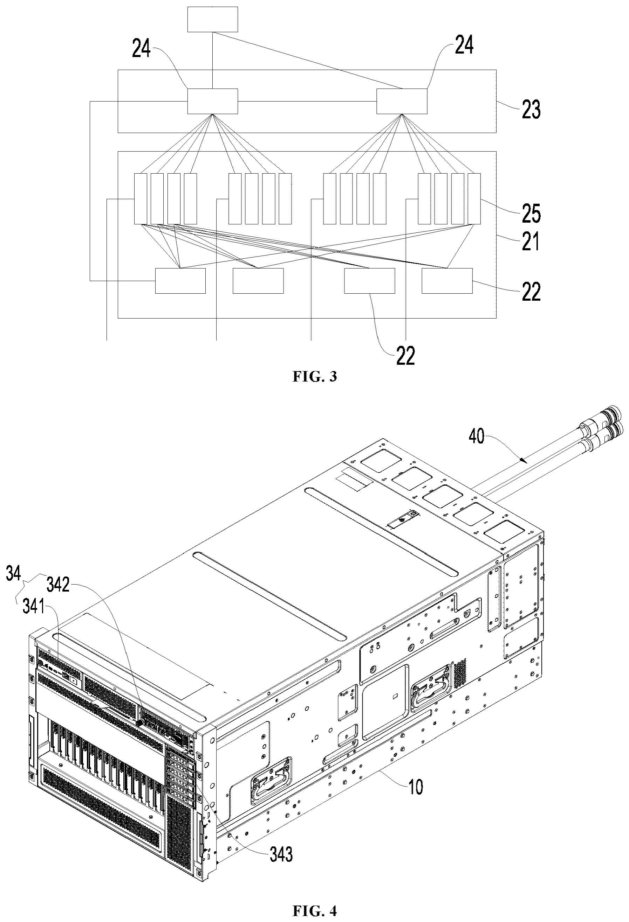

In some embodiments, as shown in FIG. 3, the server device further includes a damping hinge 31. The damping hinge 31 is coupled to the cover 15 and the chassis 10. The damping hinge 31 may control and slow down an opening speed and a closing speed of the cover 15 through a built-in damping device (such as a hydraulic device, a spring or an elastic member). In a practical operation, when the operator rotates the cover 15, the damping hinge 31 controls a movement speed of the cover 15 to allow the cover to open or close slowly and smoothly. With this arrangement, the cover 15 may move smoothly when opening and closing, avoiding the impact and noise caused by sudden closing, thereby protecting the internal electronic components from damage. In addition, the damping hinge 31 may also extend the service life of the cover 15 and the chassis 10.

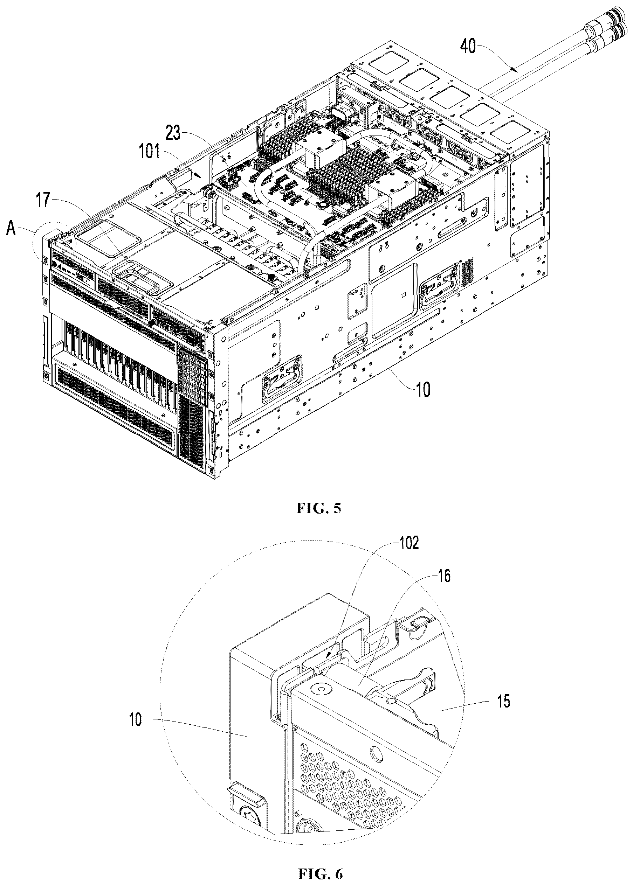

In some embodiments, as shown in FIG. 5 and FIG. 6, the chassis 10 is provided with a pair of first latching slots 102 on opposite sides of the first opening 11. The pair of first latching slots 102 may be used to fix and position the cover 15, so that the cover 15 may be stably fixed at the first opening 11 when the cover is in the closed position. In addition, the server device further includes a pair of stop assemblies 16. The pair of stop assemblies 16 are coupled to the cover 15 and respectively disposed corresponding to the pair of first latching slots 102. Specifically, when the cover 15 is in the closed position, the pair of stop assemblies 16 are respectively coupled to the pair of first latching slots 102, so that the cover 15 may be firmly fixed on the chassis 10, preventing the cover 15 from being accidentally opened.

In some embodiments, as shown in FIG. 5 and FIG. 6, the stop assembly 16 includes a pin, an elastic member, and an operating member. The pin may be inserted into the first latching slot 102 to fix the cover 15. The elastic member may be, for example, a spring. The elastic member is mounted on the pin, which allows the pin to be automatically inserted into the first latching slot 102, ensuring the stability of the cover 15. The operating member is a part for manual operation. The operator may apply an acting force to the operating member to overcome a resistance of the elastic member, so that the pin is withdrawn from the first latching slot 102, thereby opening the cover 15.

In some embodiments, as shown in FIG. 5, the server device further includes a handle 17. The handle 17 is coupled to the cover 15 and used to operate the cover 15 to open and close.

In some embodiments, as shown in FIG. 5, the handle 17 is rotatably coupled to the cover 15. When not in use, the handle 17 may be folded on the cover 15 to reduce the occupied space, thereby keeping the appearance of the chassis 10 neat and compact. When the cover 15 needs to be opened for maintenance or replacement operation, the operator may rotate the handle 17 to a position that is convenient to hold, so as to lift or rotate the cover 15 conveniently.

In some embodiments, as shown in FIG. 1, FIG. 4 and FIG. 5, a notch 13 is disposed at the front side of the chassis 10. The server device further includes a functional module 34. The functional module 34 is coupled to a side of the cover 15 facing the first region 101a and electrically connected to the main board 23. In this way, when the cover 15 is in the closed position, the functional module 34 is located at the notch 13 at the front side of the chassis 10. The operator may directly operate the functional module 34 at the notch 13 without disassembling the chassis 10 or moving the cover 15.

In some embodiments, as shown in FIG. 4, the functional module 34 may include at least one of a power control module 341 or a data transmission module 342. The power control module 341 is used to manage starting and shutting down of the server. The data transmission module 342 is responsible for data transmission and exchange, improving the data processing capability of the system. The functional module 34 is electrically connected to the main board 23, which may ensure efficient transmission of data and control signals.

It should be understood that in other embodiments, the functional module 34 may further include other required components, such as a network interface module, a storage module 343, a monitoring module, etc., to meet functional requirements in different scenarios, and the present disclosure is not intended to limit thereto.

In addition, the server device has many functions, and part of the functional module 34, such as the storage module 343, may be disposed on the front side of the chassis 10, instead of being all mounted on the cover 15. In this way, the storage module 343 is disposed on the front side of the chassis 10, which may facilitate the operator to store and manage data, and also reduce the load on the cover 15, ensuring the stability and safety of the cover 15 during opening and closing operations.

In some embodiments, as shown in FIG. 1 and FIG. 2, the server device further includes a module compartment 18. The module compartment 18 is coupled to the cover 15 and used for mounting the functional module 34. When the cover 15 is in the closed position, a height between a bottom surface of the module compartment 18 and a top surface of the carrier board 21 is greater than a height of the plurality of expansion cards 25. With this arrangement, the functional module 34 in the module compartment 18 does not interfere with the expansion cards 25 on the carrier board 21, providing sufficient space.

In some embodiments, a height of the chassis 10 may be 8 rack units, a height of the module compartment 18 may be 1 rack unit, and a sum of the heights of the expansion cards 25 and the carrier board 21 is 3 rack units. In this way, after the plurality of expansion cards 25 are installed in the chassis 10, there is still a remaining height of 4 rack units inside the chassis. This space may facilitate the subsequent upgrade of the server device. For example, without changing a frame of the chassis 10, other types of carrier boards 21 or expansion cards 25 may be replaced to adapt to different application requirements and technological advancements.

In some embodiments, as shown in FIG. 1 and FIG. 2, the server device further includes a liquid cooling assembly 40. The liquid cooling assembly 40 is disposed in the accommodating cavity 101 and coupled to the interconnection chip 22, the processing unit 24, and the plurality of expansion cards 25. The interconnection chip 22 and the processing unit 24 generate a large amount of heat during operation, and the liquid cooling assembly 40 may take away the heat by circulating the cooling liquid, ensuring that the interconnection chip 22 and the processing unit 24 may keep stable operation in a high-temperature environment. In addition, the liquid cooling assembly 40 may also reduce the temperature of the expansion cards 25, preventing performance degradation or failure caused by overheating. In this way, the server device may maintain the optimal working state under high load and long-time operation, which may meet the requirements of high-performance computing and large-scale data processing.

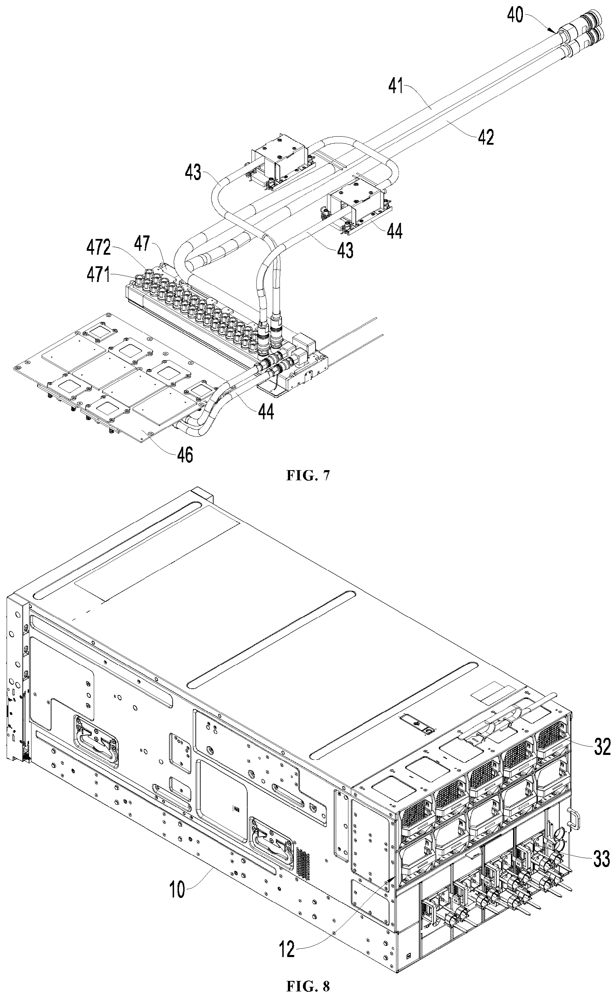

In some embodiments, as shown in FIG. 5 and FIG. 7, the liquid cooling assembly 40 includes a liquid inlet tube 41, a liquid return tube 42, a first branch 43, a first cold plate 44, a second branch 45, a second cold plate 46, and a liquid cooling adapter 47. The liquid inlet tube 41 and the liquid return tube 42 are main pipes of the liquid cooling assembly 40, which may be connected to an outdoor heat exchange unit, such as a cooling tower, a water-cooled condenser, etc. The liquid inlet tube 41 is responsible for delivering a low-temperature cooling liquid to the interior of the server, while the liquid return tube 42 returns the cooling liquid that has absorbed heat to the outdoor heat exchange unit for cooling.

The first branch 43 is communicated with the liquid inlet tube 41 and the liquid return tube 42, and is used to provide cooling for the processing unit 24. The first cold plate 44 is communicated with the first branch 43 and coupled to the processing unit 24 on the main board 23. The first cold plate 44 transfers the heat generated by the processing unit 24 to the cooling liquid through a heat conduction material, thereby effectively reducing the temperature of the processing unit 24 and ensuring that the processing unit may still run stably under a high load. When there are a plurality of processing units 24, the first cold plate 44 may include a plurality of sub-cold plates, and the plurality of sub-cold plates are respectively coupled to the plurality of processing units 24. In other embodiments, the first cold plate 44 may be a whole cold plate, and the whole cold plate is coupled to the plurality of processing units 24.

The second branch 45 is communicated with the liquid inlet tube 41 and the liquid return tube 42, and is used to provide cooling for the interconnection chip 22. The second cold plate 46 is communicated with the second branch 45 and coupled to the interconnection chip 22 on the carrier board 21. The second cold plate 46 transfers the heat generated by the interconnection chip 22 to the cooling liquid, ensuring that the interconnection chip 22 does not overheat during the efficient communication process, thereby maintaining the high performance and reliability of the system.

The liquid cooling adapter 47 is communicated with the liquid inlet tube 41 and the liquid return tube 42. The liquid cooling adapter 47 includes a plurality of liquid inlets 471 and a plurality of liquid outlets 472. The plurality of liquid inlets 471 and the plurality of liquid outlets 472 are respectively coupled to the plurality of expansion cards 25 in a one-to-one correspondence. The liquid cooling adapter 47 may enable each expansion card 25 to obtain a flow rate of the cooling liquid, thereby effectively dissipating heat.

In some cases, as shown in FIG. 7, the liquid cooling adapter 47 is communicated not only with the liquid inlet tube 41 and the liquid return tube 42, but also with the first branch 43 and the second branch 45. The liquid cooling adapter 47 may function as a flow splitter, which allows the cooling liquid to be distributed between different branches, ensuring that each critical component may obtain a sufficient flow rate of the cooling liquid, and the number of adapters in the liquid cooling assembly 40 may also be reduced.

In some embodiments, as shown in FIG. 8, a second opening 12 is disposed at the rear side of the chassis 10. The server device further includes an air cooling module 32 and a power module 33. The air cooling module 32 and the power module 33 are disposed at the second opening 12 and electrically connected to the main board 23. The air cooling module 32 rotates a fan to allow the air inside the server to circulate, which may further reduce the temperature inside the server. The power module 33 provides a stable power supply for the server to ensure the normal operation of the system.

In some embodiments, as shown in FIG. 8, a plurality of standby positions are further disposed at the second opening 12. In use, the number of the air cooling modules 32 and the number of the power modules 33 may be configured according to actual demands. For example, for a use scenario that requires a higher heat dissipation capability, the operator may increase the number of the air cooling modules 32. For a use scenario that requires a higher power supply, the operator may increase the number of the power modules 33. In this way, the server device may meet diverse application requirements.

In some embodiments, as shown in FIG. 2, FIG. 9 to FIG. 13, the server device further includes a limiting member 35. The limiting member 35 is disposed in the accommodating cavity 101 and coupled to the chassis 10. The limiting member 35 includes a plurality of limiting portions 351, and the plurality of limiting portions 351 are respectively coupled to the plurality of expansion cards 25. With this arrangement, the expansion cards 25 may be limited in position by a physical structure, preventing the expansion cards from being loosened or falling out of the slots, thereby ensuring the stability and reliability of the system.

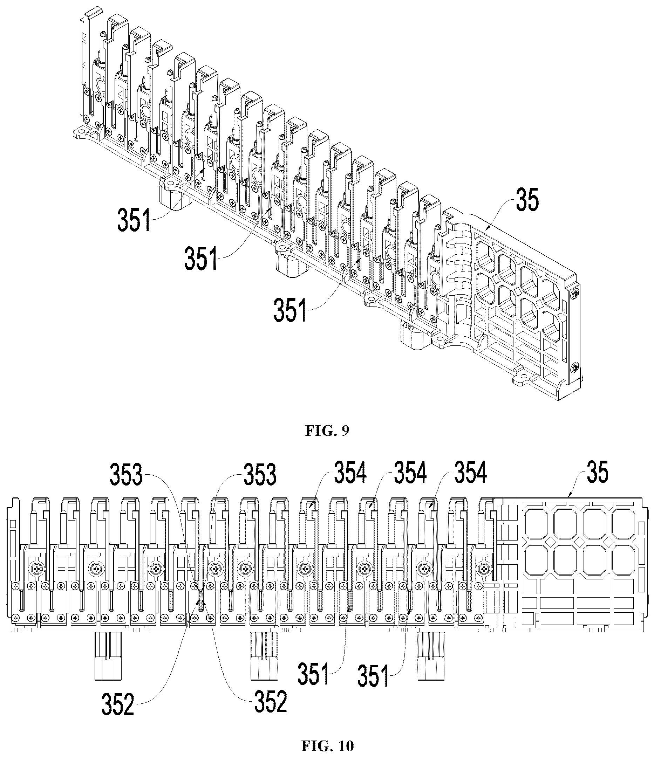

In some embodiments, as shown in FIG. 9 and FIG. 10, the limiting portion 351 includes a limiting slot. A connector 26 is disposed at one end of the expansion card 25, and the connector 26 may be inserted into the limiting slot. In this way, the limiting slot and the connector 26 are used in cooperation, and each expansion card 25 may be firmly fixed in a predetermined position, avoiding the loosening or damage caused by vibration or external impact. During the installation and maintenance process, the operator only needs to align the connector 26 with the limiting slot and push the connector hard to complete the installation. When the expansion card needs to be replaced or maintained, the expansion card 25 may be pulled out by applying an outward force, without worrying about the impact on other components.

In some embodiments, as shown in FIG. 10, a pair of protruding portions 352 are disposed in the limiting slot. The connector 26 may be inserted between the pair of protruding portions 352, and an interference fit is adopted between the connector 26 and the pair of protruding portions 352. With this arrangement, the pair of protruding portions 352 and the connector 26 form a damping structure, which may avoid the bouncing phenomenon of the expansion card 25 when being pulled out.

Specifically, in a process of the expansion card 25 being butted with the liquid cooling adapter 47, the connection between the expansion card and the liquid cooling adapter is very tight to prevent the leakage of the cooling liquid. When the expansion card 25 is pulled out from the liquid cooling adapter 47, a relatively large elastic force is generated, which may cause the expansion card 25 to jump up during the pulling-out process. The interference fit between the pair of protruding portions 352 and the connector 26 may increase a resistance when the connector 26 is inserted and pulled out, which may effectively absorb the elastic force, avoiding the jumping phenomenon of the expansion card 25.

In some embodiments, as shown in FIG. 10, a pair of inclined surfaces 353 are disposed on a side of the pair of protruding portions 352 facing the first opening 11, and the pair of inclined surfaces 353 may guide the connector 26 to be inserted between the pair of protruding portions 352. When the operator inserts the expansion card 25 into the limiting slot, the connector 26 first comes into contact with the pair of inclined surfaces 353. The connector 26 may smoothly slide between the pair of protruding portions 352 along the inclined surfaces, thereby reducing the resistance and friction during insertion, and ensuring that the connector 26 may smoothly enter the limiting slot.

In addition, the pair of inclined surfaces 353 may also reduce the alignment work during installation, improving the installation efficiency of the expansion card 25. During the installation process of the expansion card 25, the operator only needs to roughly align the expansion card 25 with the limiting slot, and the inclined surfaces 353 automatically guide the connector 26 into the correct position. In this way, the operation difficulty during installation may be reduced, making the installation process more efficient and faster.

In some embodiments, as shown in FIG. 10 to FIG. 13, a plurality of grooves 354 are disposed on a side of the limiting member 35 facing the plurality of expansion cards 25. The server device further includes a plurality of position stop assemblies 27. The plurality of position stop assemblies 27 are respectively coupled to the plurality of expansion cards 25, and the plurality of position stop assemblies 27 are respectively coupled to the plurality of grooves 354. In this way, after the expansion cards 25 are installed on the carrier board 21, each expansion card 25 is also communicated with a corresponding liquid inlet 471 and a corresponding liquid outlet 472 on the liquid cooling adapter 47. The position stop assemblies 27 may be connected to the grooves 354 on the limiting member 35, so that the expansion cards 25 are fixed in the current positions, which may prevent the expansion cards 25 from being loosened during operation, thereby avoiding the problems of the leakage of the cooling liquid or poor circuit contact.

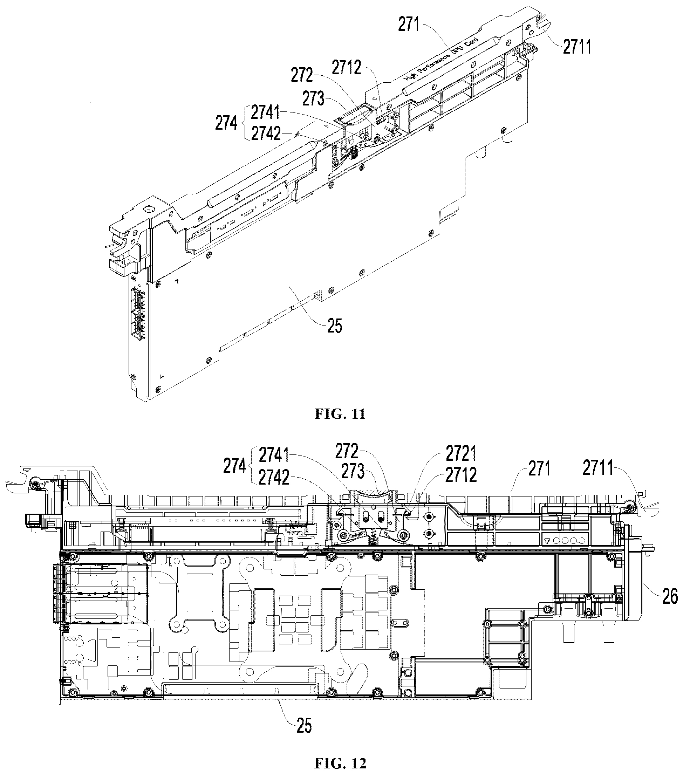

In some embodiments, as shown in FIG. 11 to FIG. 13, each position stop assembly 27 includes a connecting member 271, a fitting member 272, a button 273, and an elastic assembly 274. The connecting member 271 is rotatably coupled to the expansion card 25 and switchable between an unlocking position and a locking position. The connecting member 271 includes a first end and a second end that are opposite to each other. The first end is provided with a first protrusion 2711, and the second end is provided with a second protrusion 2712. The fitting member 272 is rotatably coupled to the expansion card 25. A second latching slot 2721 is disposed on a side of the fitting member 272, and the second latching slot 2721 allows the second protrusion 2712 to be inserted therein. The button 273 is slidably coupled to the expansion card 25 and coupled to the fitting member 272. The elastic assembly 274 is coupled to the fitting member 272 and the button 273, and the elastic assembly 274 is configured to apply, to the fitting member 272, a force that enables the second latching slot 2721 to face the connecting member 271.

When the operator inserts the expansion card 25 into the carrier board 21 and pushes the connecting member 271 to the locking position, the first protrusion 2711 of the connecting member 271 is inserted into the groove 354 on the limiting member 35, and at the same time, the second protrusion 2712 is inserted into the second latching slot 2721 of the fitting member 272, so that the expansion card 25 may be fixed in the current position, thereby avoiding the problems of the leakage of the cooling liquid and poor circuit contact caused by the loosening of the expansion card 25.

When the expansion card 25 needs to be disassembled, the operator only needs to press the button 273, and the sliding of the button 273 drives the fitting member 272 to rotate, so that the second latching slot 2721 is separated from the second protrusion 2712. At the same time, the connecting member 271 also rotates accordingly, so that the first protrusion 2711 is disengaged from the groove 354 of the limiting member 35.

In this way, the position stop assembly 27 may make the installation and disassembly process of the expansion card 25 more convenient and safer. The connecting member 271, the fitting member 272, the button 273 and the elastic assembly 274 work together, so that the expansion card 25 may remain stable when being inserted and pulled out, avoiding the risk of damage caused by improper operation.

In some embodiments, the elastic assembly 274 may include a first elastic member 2741 and a second elastic member 2742. The first elastic member 2741 is connected to the fitting member 272 and the expansion card 25. The first elastic member 2741 may be used to drive the fitting member 272 to enable the second latching slot 2721 to face the connecting member 271. The second elastic member 2742 is connected to the button 273 and the expansion card 25, and is used to drive the button 273 to be in an initial position for the next operation.

In other embodiments, the elastic assembly 274 may include only one of the first elastic member 2741 and the second elastic member 2742. As shown in FIG. 12, the button 273 is slidably coupled to the expansion card 25 and coupled to the fitting member 272. That is, a force may be transmitted between the two components, and when the first elastic member 2741 applies a force to the fitting member 272, the button 273 is also caused to move. Similarly, when the second elastic member 2742 applies a force to the button 273, the fitting member 272 is also caused to move.

The embodiments of the present disclosure are also reflected in the following examples.

Example 1. A server device, including: a chassis including an accommodating cavity and a first opening, the accommodating cavity including a first region adjacent to a front side of the chassis and a second region adjacent to a rear side of the chassis, the first opening being disposed at a top of the chassis and corresponding to the first region; a carrier board disposed in the first region and coupled to the chassis, the carrier board including an interconnection chip; a main board disposed in the second region and coupled to the chassis, the main board including a processing unit; a plurality of expansion cards detachably coupled to a side of the carrier board facing the first opening; and a cover disposed at the first opening, the cover being rotatably coupled to the chassis and switchable between a closed position and an open position, where when the cover is in the closed position, the cover covers the first opening, and when the cover is in the open position, the first opening is exposed for an operator to operate at the first opening.

Example 2. The server device according to Example 1, where a height of the carrier board in the accommodating cavity is lower than a height of the main board in the accommodating cavity.

Example 3. The server device of Example 1, further including: a damping hinge coupled to the cover and the chassis.

Example 4. The server device of Example 1, where a pair of first latching slots are disposed on two opposite sides of the chassis corresponding to the first opening, and the server device further includes: a pair of stop assemblies coupled to the cover and respectively disposed corresponding to the pair of first latching slots, where when the cover is in the closed position, the pair of stop assemblies are respectively coupled to the pair of first latching slots.

Example 5. The server device of Example 1, further including: a handle coupled to the cover, the handle being used to operate the cover.

Example 6. The server device of any of Examples 1 to 5, where a notch is disposed at the front side of the chassis, and the server device further includes: a functional module coupled to a side of the cover facing the first region and electrically connected to the main board, where when the cover is in the closed position, the functional module is located at the notch for an operator to operate the functional module at the notch.

Example 7. The server device of Example 6, where the functional module includes at least one of a power control module or a data transmission module.

Example 8. The server device of Example 6, further including: a module compartment coupled to the cover to mount the functional module, and when the cover is in the closed position, a height between a bottom surface of the module compartment and a top surface of the carrier board is greater than a height of the plurality of expansion cards.

Example 9. The server device of any of Examples 1 to 5, 7 and 8, further including: a liquid cooling assembly disposed in the accommodating cavity and coupled to the interconnection chip, the processing unit, and the plurality of expansion cards.

Example 10. The server device of Example 9, the liquid cooling assembly including: a liquid inlet tube and a liquid return tube; a first branch communicated with the liquid inlet tube and the liquid return tube; a first cold plate communicated with the first branch and coupled to the processing unit; a second branch communicated with the liquid inlet tube and the liquid return tube; a second cold plate communicated with the second branch and coupled to the interconnection chip on the carrier board; and a liquid cooling adapter communicated with the liquid inlet tube and the liquid return tube, the liquid cooling adapter including a plurality of liquid inlets and a plurality of liquid outlets, and the plurality of liquid inlets and the plurality of liquid outlets being respectively coupled to the plurality of expansion cards in a one-to-one correspondence.

Example 11. The server device of any of Examples 1 to 5, 7, 8 and 10, where a second opening is disposed at the rear side of the chassis, and the server device further includes: an air cooling module disposed at the second opening and electrically connected to the main board; and a power module disposed at the second opening and electrically connected to the main board.

Example 12. The server device of any of Examples 1 to 5, 7, 8 and 10, further including: a limiting member disposed in the accommodating cavity and coupled to the chassis, the limiting member including a plurality of limiting portions, and the plurality of limiting portions being respectively coupled to the plurality of expansion cards to limit positions of the plurality of expansion cards.

Example 13. The server device of Example 12, where the limiting portion includes a limiting slot, and a connector is disposed at an end of the expansion card and is capable of being inserted into the limiting slot.

Example 14. The server device of Example 13, where a pair of protruding portions are disposed in the limiting slot, the connector is capable of being inserted between the pair of protruding portions, and the connector is in an interference fit with the pair of protruding portions.

Example 15. The server device of Example 14, where a pair of inclined surfaces are disposed on a side of the pair of protruding portions facing the first opening, and the pair of inclined surfaces are capable of guiding the connector to be inserted between the pair of protruding portions.

Example 16. The server device of Example 12, where a plurality of grooves are disposed on a side of the limiting member facing the plurality of expansion cards, and the server device further includes: a plurality of position stop assemblies respectively coupled to the plurality of expansion cards, and the plurality of position stop assemblies being respectively coupled to the plurality of grooves to limit positions of the plurality of expansion cards.

Example 17. The server device of Example 16, where each of the position stop assemblies includes: a connecting member rotatably coupled to the expansion card and being switchable between an unlocking position and a locking position, the connecting member including a first end and a second end that are opposite to each other, the first end being provided with a first protrusion, and the second end being provided with a second protrusion; a fitting member rotatably coupled to the expansion card, and a second latching slot being disposed on a side of the fitting member and allowing the second protrusion to be inserted therein; a button slidably coupled to the expansion card and coupled to the fitting member; and an elastic assembly coupled to the fitting member and the button, the elastic assembly being configured to apply, to the fitting member, a force that enables the second latching slot to face the connecting member; where when the connecting member is in the locking position, the second protrusion is inserted into the second latching slot, and the first protrusion is located outside an edge of the expansion card and inserted into a corresponding groove; and when the connecting member is in the unlocking position, the second protrusion is separated from the second latching slot, and the first protrusion is separated from the corresponding groove.

Embodiments of the present disclosure have been described above, and the above description is illustrative, non-exhaustive, and not limited to the disclosed embodiments. Many modifications and variations will be apparent to those of ordinary skill in the art without departing from the scope of the described embodiments. The terminology used herein is chosen to best explain the principles of the embodiments, the practical application or the technical improvement to the market, or to enable other those of ordinary skill in the art to understand the embodiments disclosed herein.

## Claims

1. A server device, comprising:
a chassis (10) comprising an accommodating cavity (101) and a first opening (11), the accommodating cavity (101) comprising a first region (101a) adjacent to a front side of the chassis (10) and a second region (101b) adjacent to a rear side of the chassis (10), the first opening (11) being disposed at a top of the chassis (10) and corresponding to the first region (101a);
a carrier board (21) disposed in the first region (101a) and coupled to the chassis (10), the carrier board (21) comprising an interconnection chip (22);
a main board (23) disposed in the second region (101b) and coupled to the chassis (10), the main board (23) comprising a processing unit (24);
a plurality of expansion cards (25) detachably coupled to a side of the carrier board (21) facing the first opening (11); and
a cover (15) disposed at the first opening (11), the cover (15) being rotatably coupled to the chassis (10) and switchable between a closed position and an open position, wherein when the cover (15) is in the closed position, the cover (15) covers the first opening (11), and when the cover (15) is in the open position, the first opening (11) is exposed for an operator to operate at the first opening (11).

2. The server device of claim 1, wherein a height of the carrier board (21) in the accommodating cavity (101) is lower than a height of the main board (23) in the accommodating cavity (101).

3. The server device of claim 1 or 2, further comprising:
a damping hinge (31) coupled to the cover (15) and the chassis (10).

4. The server device of any one of claims 1 to 3, wherein a pair of first latching slots (102) are disposed on two opposite sides of the chassis (10) corresponding to the first opening (11), and the server device further comprises:
a pair of stop assemblies (16) coupled to the cover (15) and respectively disposed corresponding to the pair of first latching slots (102), wherein when the cover (15) is in the closed position, the pair of stop assemblies (16) are respectively coupled to the pair of first latching slots (102).

5. The server device of any one of claims 1 to 4, further comprising:
a handle (17) coupled to the cover (15), the handle (17) being used to operate the cover (15).

6. The server device of any one of claims 1 to 5, wherein a notch (13) is disposed at the front side of the chassis (10), and the server device further comprises:
a functional module (34) coupled to a side of the cover (15) facing the first region (101a) and electrically connected to the main board (23), wherein when the cover (15) is in the closed position, the functional module (34) is located at the notch (13) for the operator to operate the functional module (34) at the notch (13).

7. The server device of claim 6, wherein the functional module (34) comprises at least one of a power control module (341) or a data transmission module (342).

8. The server device of claim 6 or 7, further comprising:
a module compartment (18) coupled to the cover (15) to mount the functional module (34), and when the cover (15) is in the closed position, a height between a bottom surface of the module compartment (18) and a top surface of the carrier board (21) is greater than a height of the plurality of expansion cards (25).

9. The server device of any one of claims 1 to 8, further comprising:
a liquid cooling assembly (40) disposed in the accommodating cavity (101) and coupled to the interconnection chip (22), the processing unit (24), and the plurality of expansion cards (25).

10. The server device of claim 9, the liquid cooling assembly (40) comprising:
a liquid inlet tube (41) and a liquid return tube (42);
a first branch (43) communicated with the liquid inlet tube (41) and the liquid return tube (42);
a first cold plate (44) communicated with the first branch (43) and coupled to the processing unit (24);
a second branch (45) communicated with the liquid inlet tube (41) and the liquid return tube (42);
a second cold plate (46) communicated with the second branch (45) and coupled to the interconnection chip (22) on the carrier board (21); and
a liquid cooling adapter (47) communicated with the liquid inlet tube (41) and the liquid return tube (42), the liquid cooling adapter (47) comprising a plurality of liquid inlets (471) and a plurality of liquid outlets (472), and the plurality of liquid inlets (471) and the plurality of liquid outlets (472) being respectively coupled to the plurality of expansion cards (25) in a one-to-one correspondence.

11. The server device of any one of claims 1 to 10, wherein a second opening (12) is disposed at the rear side of the chassis (10), and the server device further comprises:
an air cooling module (32) disposed at the second opening (12) and electrically connected to the main board (23); and
a power module (33) disposed at the second opening (12) and electrically connected to the main board (23).

12. The server device of any one of claims 1 to 11, further comprising:
a limiting member (35) disposed in the accommodating cavity (101) and coupled to the chassis (10), the limiting member (35) comprising a plurality of limiting portions (351), and the plurality of limiting portions (351) being respectively coupled to the plurality of expansion cards (25) to limit positions of the plurality of expansion cards (25).

13. The server device of claim 12, wherein the limiting portion (351) comprises a limiting slot, and a connector (26) is disposed at an end of the expansion card (25) and is capable of being inserted into the limiting slot, and/or
wherein a plurality of grooves (354) are disposed on a side of the limiting member (35) facing the plurality of expansion cards (25), and the server device further comprises:
a plurality of position stop assemblies (27) respectively coupled to the plurality of expansion cards (25), and the plurality of position stop assemblies (27) being respectively coupled to the plurality of grooves (354) to limit positions of the plurality of expansion cards (25).

14. The server device of claim 13, wherein a pair of protruding portions (352) are disposed in the limiting slot, the connector (26) is capable of being inserted between the pair of protruding portions (352), and the connector (26) is in an interference fit with the pair of protruding portions (352), and/or
wherein a pair of inclined surfaces (353) are disposed on a side of the pair of protruding portions (352) facing the first opening (11), and the pair of inclined surfaces (353) are capable of guiding the connector (26) to be inserted between the pair of protruding portions (352).

15. The server device of claim 13 or 14, wherein each of the position stop assemblies (27) comprises:
a connecting member (271) rotatably coupled to the expansion card (25) and being switchable between an unlocking position and a locking position, the connecting member (271) comprising a first end and a second end that are opposite to each other, the first end being provided with a first protrusion (2711), and the second end being provided with a second protrusion (2712);
a fitting member (272) rotatably coupled to the expansion card (25), and a second latching slot (2721) being disposed on a side of the fitting member (272) and allowing the second protrusion (2712) to be inserted therein;
a button (273) slidably coupled to the expansion card (25) and coupled to the fitting member (272); and
an elastic assembly (274) coupled to the fitting member (272) and the button (273), the elastic assembly (274) being configured to apply, to the fitting member (272), a force that enables the second latching slot (2721) to face the connecting member (271);
wherein when the connecting member (271) is in the locking position, the second protrusion (2712) is inserted into the second latching slot (2721), and the first protrusion (2711) is located outside an edge of the expansion card (25) and inserted into a corresponding groove (354); and when the connecting member (271) is in the unlocking position, the second protrusion (2712) is separated from the second latching slot (2721), and the first protrusion (2711) is separated from the corresponding groove (354).
